# EUROPEAN PATENT APPLICATION

(11) **EP 1 775 764 A1**
(43) Date of publication of application: **18.04.2007**
(21) Application number: 05741482.3
(22) Date of filing: 23.05.2005
(51) Int. Cl.: H01L 21/822, H01L 27/04

(54) **SEMICONDUCTOR DEVICE AND ELECTRONIC DEVICE**

(30) Priority: 01.06.2004 JP 2004163460
(71) Applicant: ROHM CO., LTD., Kyoto-shi, Kyoto 615-8585 (JP)
(72) Inventor: TAKIHARA, Hirotaka c/o Rohm Co., Ltd., Kyoto-shi, Kyoto 6158585 (JP); KAJIWARA, Youichi c/o Rohm Co., Ltd., Kyoto-shi, Kyoto 6158585 (JP); TSUCHIHASHI, Masanori c/o Rohm Co., Ltd., Kyoto-shi, Kyoto 6158585 (JP)
(74) Representative: McLeish, Nicholas Alistair Maxwell
(86) International application number: PCT/JP2005/009391
(87) International publication number: WO 2005/119759

(57) **Abstract**

In a semiconductor device (10), a problem of heat generation and power loss is alleviated, and the semiconductor device (10) is protected against the failure due to the overcurrent. The semiconductor device (10) includes an IC chip (20) having a large-current output. In the IC chip a measuring terminal (Pw1) is electrically connected with a first pad (Pi1) via a gold wire. A potential difference generated by the impedance (Rp1) of the gold wire is compared with a predetermined value. When the potential difference exceeds the predetermined threshold level, the semiconductor devices operates to turn off a PMOS-type transistor (Q1).

## Description

### TECHNICAL FIELD

The present invention relates to a semiconductor device and an electronic apparatus and it particularly relates to a semiconductor device, where an IC chip is built therein and a pad in the IC chip side is electrically connected with an external terminal of an IC by a bonding wire (hereinafter referred to simply as "wire"), and an electronic apparatus equipped with the semiconductor device.

### BACKGROUND TECHNOLOGY

Presently, many semiconductor components are incorporated into various electronic equipment. The semiconductor components have a wide variety of usages. They are used under severe circumstances depending on the use or they are used under such a condition that they can be easily touched from the outside. In such a case, for example, when defects like short-circuiting occur, there are cases where the excessive current as compared to the current normally anticipated flows through the semiconductor components. In such a case, it is possible that defects such as open and short-circuit is caused in part of the semiconductor components and this malfunction then has adverse effects on the external circuits or apparatus. In order to resolve this problem, a technique by which to protect the circuit is known where a resistor element is provided to detect the excess current generated at the time when the short-circuiting or the like occurs between the output terminals, etc. and the load or between the power supply and the ground (Patent Documents 1 and 2).
[Patent Document 1]
Japanese Patent Application Laid-Open No. Hei05-268724.
[Patent Document 2]
Japanese Patent Application Laid-Open No. Hei06-54865.

### [DISCLOSURE OF THE INVENTION]

### [Problems to be solved by the invention]

According to Patent Document 1 and Patent Document 2, a resistor element that detects the current is used to protect elements inside the semiconductor components. However, as a natural consequence thereof, there is a problem where the heat is generated by the resistor element itself and the power is consumed thereby as a loss.

The inventors invented the present invention based on the above recognition and an object thereof is to provide a semiconductor device and an electronic apparatus which alleviate such problems as heat generation and power loss.

### [MEANS FOR SOLVING THE PROBLEMS]

One embodiment of the present invention relates to a semiconductor device. This device has an IC chip, the IC chip includes an overcurrent protection circuit, and the overcurrent protection circuit comprises: a first pad connected with an external input terminal; a measuring terminal electrically connected with the first pad via a wire having a predetermined resistive component wherein the measuring terminal is not connected with any of external terminals; a second pad connected to an external output terminal; a switch circuit which turns on and off electric connection between the measuring terminal and the second pad; and a comparator which turns off the switch circuit when difference in potential between the first pad and the measuring terminal exceeds a predetermined value. A semiconductor device according to the present invention may further include, besides the comparator, a control circuit which turns on and off the switch circuit according to a predetermined logical control.

According to this embodiment, if the voltage potential difference caused in the resistive component of a predetermined wire is greater than an expected value, the switch circuit is turned on so as to protect the semiconductor device from the failure caused by the excess current. As a result, it facilitates suppressing the failure of the external load device from being induced by the failure of the semiconductor device. Instead of the external resistor, which is susceptible to the effect of large variation in connection resistance, wire resistance or the like, and the diffused resistor whose variation in resistance value is large, there is utilized the resistive component that a predetermined wire has. Hence, the problems of heat generation and power loss are alleviated.

The measuring terminal of the semiconductor device according to the present invention may be a pad. Also, after the IC chip is formed, the wire may be formed external to the IC chip. In this manner, the wire between the first pad and the measuring terminal is formed outside, so that the present characteristics of the IC chip can remain intact and the characteristics are stabilized even after the formation of the wire. The external wire may be formed of gold. That is, by the use of gold wiring in place of the aluminum wiring, the problem of corrosion and migration due to prolonged use can be alleviated and therefore high reliability can be realized. A semiconductor device according to the present invention is may be such that there are provided a plurality of the overcurrent protection circuits which share the second pad.

Another embodiment of the present invention relates to an electronic apparatus. This apparatus comprises: an above-described semiconductor device; and a predetermined load device which is driven by a motor drive circuit, such as an H-bridge circuit, formed by the semiconductor device. Here, the load device indicates a device, such as a motor, which operates by utilizing the semiconductor device as a power supply.

An electronic apparatus according to the present invention may be used for a vehicle and the predetermined value may be determined based on a failure anticipated in the load device in the vehicle. In that case, the advantages in the above-mentioned electronic apparatus or semiconductor device can also be enjoyed in the electronic apparatus for use in vehicles. The vehicles are generally used under severe circumstances or the requested specifications therefor is very demanding, so that it is effective to apply the electronic apparatus of the present invention to the vehicle use.

### [EFFECTS OF THE INVENTION]

According to the present invention, there can be provided a semiconductor device and an electronic apparatus that enhance the long-term reliability and alleviate the problem of heat generation and power loss.

### [BRIEF DESCRIPTION OF THE DRAWINGS]

FIG. 1 is a diagram showing a structure of a first electronic apparatus according to a first embodiment.
FIG. 2 is an exterior view showing a state in which the first pad Pi1 and the measuring terminal Pw1 are electrically connected to each other by a gold wiring Lg.
FIG. 3 shows a structure of a second electronic apparatus according to a second embodiment.

### DESCRIPTION OF REFERENCE NUMERALS

10 semiconductor device, 20 IC chip, 22 control circuit, 30 overcurrent protection circuit, 31 load device, 40 first electronic apparatus, 50 second electronic apparatus, Pi1, Po3 first pad, Pw1, Pw2 measuring terminal, Po1, second pad, Pi2 external input terminal, Po2, Po4 external output terminal, Wi1, Wo1, Wo2 bonding wire, Lg gold wire, C1, C2, C3, C4 comparator, Q1, Q3 PMOS-type transistor, Q2, Q4 NMOS-type transistor

### [THE BEST MODE FOR CARRYING OUT THE INVENTION]

### (First embodiment)

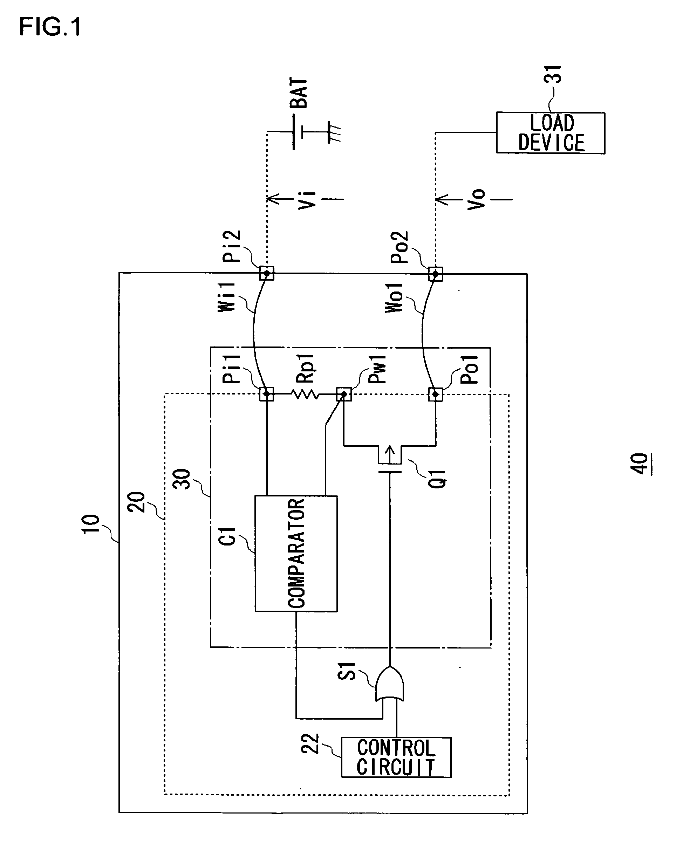

FIG. 1 is a diagram showing a structure of a first electronic apparatus according to a first embodiment. The first electronic apparatus 40 is comprised of a semiconductor device 10 and a load device 31. This structure represents a circuit for driving the load device 31 such as a coil or motor, and accordingly it includes a control circuit 22 to achieve a normal operation. On the other hand, the semiconductor device 10 has a separate function, in addition to the normal operation, of shutting off the current to countermeasure the overcurrent. In a case when the semiconductor device 10 is used for a vehicle, for example, and is often used under harsh environments such as severe heat and severe coldness, the load device 31 may suffer closed-circuit failure. Also, in a case when an external output terminal Po2 described later is shortcircuited with other output terminals, power supply, grounding and the like, the resistance drops extremely and the overcurrent continues to flow into the load device 31. As a result, the load device 31 generates heat, which in turn may affect the reliability thereof. Thus, it is meaningful to protect the semiconductor device 10 against the overcurrent generated.

The semiconductor device 10 supplies the electric power to an external load device 31. The semiconductor device 10 has an external input terminal Pi2 and an external output terminal Po2, which are lead terminals, wherein a battery BAT as a power supply is connected with the external input terminal Pi2 and, for example, an input voltage Vi of 4.5 V is supplied thereto. For example, an output voltage Vo of 3.0 V is supplied to the load device 31.

The semiconductor device 10 has an IC chip that constitutes a series regulator, for example. This IC chip 20 includes an overcurrent protection circuit 30, an OR gate S1 and a control circuit 22, the detail of which will be described later. The overcurrent protection circuit 30 includes a first pad Pi1, a measuring terminal Pw1, a second pad Po1, an impedance Rp1, a comparator C1, and a PMOS-type transistor Q1. The semiconductor device 10 supplies an input voltage Vi to the internal IC chip 20 via an input wire Wi1, and an output voltage Vo is acquired from the IC chip 20 via an output wire Wo1.

A description will be given hereinabelow of a structure of the IC chip 20. The IC chip 20 includes a first pad Pi1 which receives the input voltage Vi from the power supply, a second pad Po1 which outputs an output voltage Vo for the purpose of performing a control, and a measuring terminal Pw1, electrically connected with the first pad Pi1 by a gold wiring, which is not wire-connected with any external terminals. A resistance component, which is generated by the use of the gold wiring, is shown schematically as an impedance Rp1. On the other hand, a PMOS-type transistor Q1 is connected between the measuring terminal Pw1 and the second pad Po1. Here, a pad is provided to verify, on the wafer level, the value of the impedance Rp1 or the operation of the comparator C1 described later. Note that the measuring terminal Pw1 is not necessary a pad.

As a normal operation, the control circuit 22 outputs "0" corresponding to a low level when the current is to be delivered to the semiconductor device 10 or load device 31. It outputs "1" corresponding to a high level when no current is to be delivered thereto. In addition to such a normal operation, the comparator C1 and the OR gate S1 are provided inside the IC chip 20 and used in combination with the control circuit 22 in order to countermeasure the overcurrent.

The comparator C1 compares a difference in potential across the impedance Rp1 of a gold wiring provided between the first pad Pi1 and the measuring terminal Pw1 with a predetermined threshold level. And when the potential difference exceeds the predetermined threshold level, it so operates as to turn off the PMOS-type transistor Q1. More specifically, the comparator C1 outputs "1" if the PMOS-type transistor Q1 is to be turned off, whereas it outputs "0" if it is to be turned on. Note that a structure may be such that the threshold level is determined by a user depending on the usage environment, required specifications or the like.

The threshold level may have a value determined on the assumption that there are various kinds of failures. For example, if the load device 31 such as a coil installed in a vehicle malfunctions due to short-circuiting, the aforementioned threshold level will be determined depending on how much of it suffers short-circuit. If it is assumed that the entire parts suffer short-circuit, the resistance value will drop extremely fast and, as a result thereof, the value of current flowing to the semiconductor device 10 will be very large. Thus, for example, if the maximum value of current which is expected to normally flow is 1 A (ampere), the potential difference which is calculated from 3 A (ampere), namely three times 1 A, may be determined as the threshold level. If, otherwise, it is assumed that only a portion of them suffers short-circuit, the resistance value of the load device 31 will drop slightly and, as a result thereof, the value of current flowing to the semiconductor device 10 will be slightly larger. Thus, for example, if the maximum value of current which is expected to normally flow is 1 A (ampere), the potential difference which is calculated from 1.5 A (ampere), namely 1.5 times 1 A, may be determined as the threshold level, which is stricter than the above example.

The OR gate S1 performs OR-operation on the output signal from the comparator C1 and the output signal from the control circuit 22, and outputs the result to the PMOS-type transistor Q1. Since the output of the comparator C1 is "0", this does not affect the normal operation of the control circuit 22 unless an overcurrent is detected. If, however, the overcurrent occurs, the potential difference across the impedance Rp1 on the gold wire will be larger than a predetermined threshold level and the output of the comparator C1 will be "1". Hence, the output of the control circuit 22 will be ignored and the PMOS-type transistor Q1 will be forcibly turned off.

According to the above structure, the semiconductor device 10 can be protected against the failure due to the overcurrent. Further, the structure can suppress the failure of the external load device 31 from being induced by the failure of the semiconductor device 10. Particularly in the case of the first electronic apparatus 40 used for a vehicle, the vehicles are generally used under severe circumstances or the requested specifications therefor is very demanding, so that it is further effective.

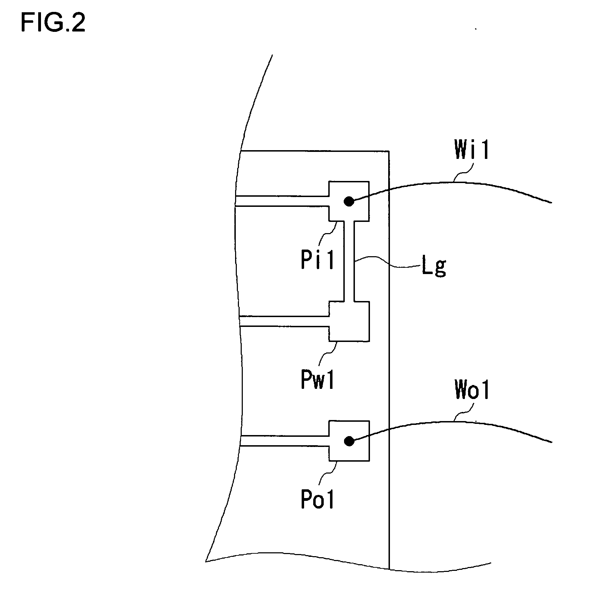

FIG. 2 is an exterior view showing a state in which the first pad Pi1 and the measuring terminal Pw1 are electrically connected to each other by a gold wire Lg. After the IC chip 20 has been formed, the gold wire Lg is externally formed on the IC chip 20. Hereinbelow, the components equivalent to those in FIG. 1 will be given the same reference numerals and the explanation thereof will be omitted where appropriate.

As for the gold wire Lg, the length and width thereof are adjusted, so that the value of the impedance Rp1 can be adjusted to a desired value. Instead of using the resistor element or the impedance of the aluminum wiring, the impedance by the gold wire Lg is utilized, so that the problem of heat generation and power loss can be alleviated; and the gold wire Lg is utilized instead of the aluminum wire, so that the problem of corrosion and migration due to prolonged use can be alleviated; hence, high reliability can be realized.

As shown in the same Figure, the gold wire Lg between the first pad Pi1 and the measuring terminal Pw1 is formed externally on the IC chip 20, so that it can be formed while the present characteristics of the IC chip 20 is kept intact. Thus, the designing can be done by still using the existing characteristics.

### (Second embodiment)

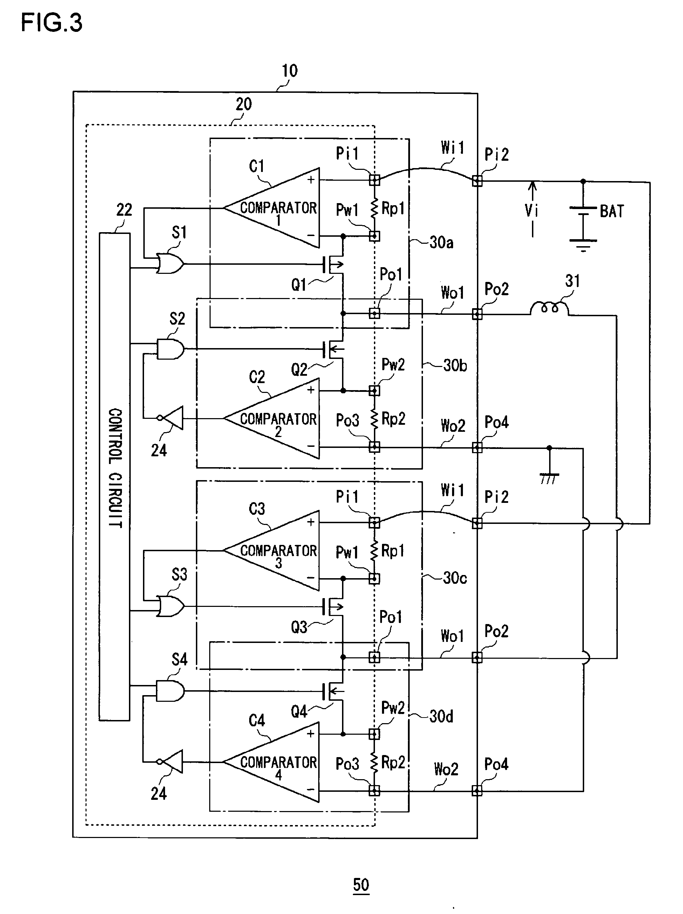

FIG. 3 shows a structure of a second electronic apparatus 50 according to a second embodiment. This second electronic apparatus 50 is an output stage of a motor driver. Hereinbelow, the components equivalent to those in the first embodiment are given the same reference numerals and the explanation thereof will be omitted as appropriate. What the present embodiment differs from the first embodiment is that there are four transistors, and an H-bridge circuit is constituted by using these. The arrangement of the first PMOS-type transistor Q1 is the same as that in the first embodiment. In the IC chip 20 a first overcurrent protection circuit 30a having the PMOS-type transistor Q1 and a second overcurrent protection circuit 30b having an NMOS-type transistor Q2 are electrically connected so that the drains thereof are commonly used. As a result, the second overcurrent protection circuit 30b can use commonly a second pad Po1 in the first overcurrent protection circuit 30a, and controls a load device 31, namely the voltage applied to one end of a coil, via an external output terminal Po2 which is wire-connected with a second pad Po1. The H-bridge circuit can be structured by further combining, as shown in the Figure, two pairs of circuits constituted by combining the first overcurrent protection circuit 30a and the second overcurrent protection circuit 30b as above. One of the above-described two pairs of circuits includes a third overcurrent protection circuit 30c and a fourth overcurrent protection circuit 30d. The configurations of the third overcurrent protection circuit 30c and the fourth overcurrent protection circuit 30d are similar to those of the first overcurrent protection circuit 30a and the second overcurrent protection circuit 30b, respectively.

The signal from a comparator C1 in the first overcurrent protection circuit 30a is inputted to an OR gate S1, whereas the signal from a comparator C2 in the second overcurrent protection circuit 30b is inverted, en route, by an inverting circuit 24 and then inputted to an AND gate S2. Similarly, the signal from a comparator C3 in the third overcurrent protection circuit 30c is inputted to an OR gate S3, whereas the signal from a comparator C4 in the fourth overcurrent protection circuit 30d is inverted by an inverting circuit 24 before it is inputted to an AND gate S4. The signal from the control circuit 22 is inputted to the OR gate S1, the AND gate S2, the OR gate S3 and the AND gate S4.

The first pad Po3, a measuring terminal Pw2, an impedance Rp2 of a gold wire, an output wire Wo2 and an external output terminal Po4 in the second overcurrent protection circuit 30b correspond respectively to the first pad Pi1, the measuring terminal Pw1, the impedance Rp1 of the gold wire, the input wire Wi1 and the external input terminal Pi2 in the first overcurrent protection circuit 30a. However, the current flows to the first pad Pi1 from the external input terminal Pi2 via the input wire Wi in the first overcurrent protection circuit 30a, whereas the current flows to the external output terminal Po4 sequentially in the order of the external output terminal Po2, the second pad Po1, the first pad Po3 and the output wire Wo2 in the second overcurrent protection circuit 30b.

Hereafter, a description is given of an operation of the second overcurrent protection circuit 30b in the second electronic apparatus 50 shown in FIG. 3. An AND gate S2 performs an AND operation on the output signal from the comparator C2 and the output signal from the control circuit 22, and outputs the result to the NMOS-type transistor Q2. The output of the comparator C2, which is normally "0", is inverted, en route, to "1" by an inverting circuit 24 and inputted to the AND gate S2. This does not affect the normal operation of the control circuit 22 unless an overcurrent is detected. If, however, the overcurrent occurs, the potential difference across the impedance Rp1 on the gold wire will be larger than a predetermined threshold level and the output of the comparator C2 will be "1", namely the signal inputted to the AND gate S2 will be "0". Hence, the output of the control circuit 22 will be ignored and the NMOS-type transistor Q2 will be forcibly turned off. The fourth overcurrent protection circuit 30d operates the same way as the second overcurrent protection circuit 30b.

When an overcurrent occurs, the comparator C1 can possibly turn off the PMOS-type transistor Q1 in the first overcurrent protection circuit 30a and the comparator C2 can possibly turn off the NMOS-type transistor Q2 in the second overcurrent protection circuit 30b. And the overcurrent can be shut off in any path in an H-bridge circuit configured by those circuits.

Thereby, the problem can be avoided where the overcurrent continues to flow to the semiconductor device 10 or the load device 31 (which is a coil here) and then an device fails to operate. In particular, the second electronic apparatus 50, for use in a vehicle, having an H-bridge circuit often delivers a certain degree of current to the load device 31 and a concept of shutting off the overcurrent is required. In the light of this, it is more effective to combine four of overcurrent protection circuits 30, for shutting off the overcurrent, in the first embodiment, and the second electronic apparatus 50 can enjoy the same advantage as with the first embodiment.

The present invention has been described based on the embodiments. The embodiments are merely exemplary, and it is understood by those skilled in the art that various modifications are possible and that such modifications are also within the scope of the present invention.

Such modifications will now be described. For example, an NMOS-type transistor may be used though the PMOS-type transistor is used in the first embodiment. In the second embodiment, a PMOS-type transistor is used for the first overcurrent protection circuit 30a and an NMOS-type transistor is used for the second overcurrent protection circuit 30b. However, an NMOS-type transistor may be used for the first overcurrent protection circuit 30a and a PMOS-type transistor may be used for the second overcurrent protection circuit 30b. The PMOS-type transistor may be used for the both. Or, the NMOS-type transistor may be used for the both. Though MOS transistors are used in the embodiments, it goes without saying that the transistor may be of a bipolar type.

The series regulator and the H-bridge circuit have been described as embodiments. As another modification, the electronic apparatus may be equipped with other regulators such as a switching regulator and a charge-pump type regulator. Also, it may be a motor driver circuit that derives a three-phase motor.

A description has been given of a semiconductor device where the pad in the IC chip side and the external terminal of the IC is connected by a wire in the first and the second embodiment. However, the semiconductor device may be one implementing a flip chip that achieves the densification. Thereby, if the electronic equipment such as a camera or a mobile phone that demands further downsizing and more sophisticated features is equipped with aforementioned flip-flop, the same effects described as in the first and the second embodiment can be enjoyed.

### [Industrial applicability]

According to the present invention, provided are a semiconductor device and an electronic apparatus which enhance the long-term reliability and alleviate the problems of heat generation and power loss.

## Claims

1. A semiconductor device having an IC chip, said IC chip including:
an overcurrent protection circuit which comprises:
a first pad connected with an external input terminal;
a measuring terminal electrically connected with the first pad via a wire having a predetermined resistive component wherein the measuring terminal is not connected with any of external terminals;
a second pad connected to an external output terminal;
a switch circuit which turns on and off electric connection between the measuring terminal and the second pad; and
a comparator which turns off the switch circuit when difference in potential between the first pad and the measuring terminal exceeds a predetermined value.

2. A semiconductor device according to Claim 1, further including, besides the comparator, a control circuit which turns on and off the switch circuit according to a predetermined logical control.

3. A semiconductor device according to Claim 1 or 2, wherein the measuring terminal is a pad.

4. A semiconductor device according to any of Claim 1 to Claim 3, wherein after the IC chip is formed, the wire is formed external to the IC chip.

5. A semiconductor device according to Claim 4, wherein the wire is formed of gold.

6. A semiconductor device according to any of Claim 1 to Claim 4, wherein there are provided a plurality of the overcurrent protection circuits which share the second pad.

7. An electronic apparatus, comprising:
a semiconductor device according to any of Claim 2 to Claim 6; and
a predetermined load device which is driven by an H-bridge circuit formed by said semiconductor device.

8. An electronic apparatus according to Claim 7, wherein said electronic apparatus is used for a vehicle and the predetermined value is determined based on a failure anticipated in said load device in the vehicle.
